# EUROPEAN PATENT SPECIFICATION

(11) **EP 3 597 021 B1**
(45) Date of publication and mention of the grant of the patent: **04.11.2026**
(21) Application number: 18719807.2
(22) Date of filing: 17.04.2018
(51) Int. Cl.: F28D 15/02, F28F 1/14, H10W 40/43, H05K 7/20

(54) **HEAT SINK AND FREQUENCY CONVERTER**
KÜHLKÖRPER UND FREQUENZUMRICHTER
DISSIPATEUR THERMIQUE ET CONVERTISSEUR DE FRÉQUENCE

(30) Priority: 19.04.2017 CN 201720418240 U
(43) Date of publication of application: 22.01.2020
(73) Proprietor: Siemens Aktiengesellschaft, 80333 München (DE)
(72) Inventor: SUN, Yao, Nanjing 211100 (CN)
(74) Representative: Isarpatent
(86) International application number: PCT/EP2018/059768
(87) International publication number: WO 2018/192919

(56) References cited:
- EP-A1- 2 315 340
- WO-A1-2012/098780
- DE-A1- 102014 012 349
- DE-U1- 202010 018 161
- US-A1- 2002 036 889
- US-A1- 2006 227 504
- US-A1- 2009 168 356
- US-A1- 2011 051 370
- US-A1- 2012 044 646
- US-A1- 2013 291 564
- US-A1- 2016 285 295

## Description

### Technical field

The present invention relates to a heat sink suitable for a frequency converter and/or a driver, and a frequency converter employing such a heat sink.

### Background art

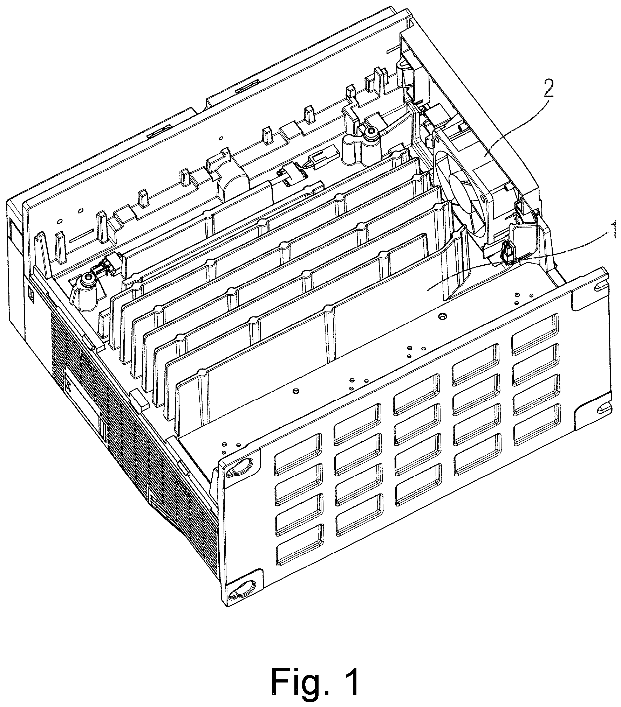

In the motion control field, for example in large frequency converters and/or driver equipment, heat dissipation is of vital importance. For instance, fig. 1 shows a conventional heat sink used in a frequency converter, chiefly formed of multiple cooling fins 1 arranged side by side and a fan 2. However, such a heat sink has a low heat dissipation efficiency per unit volume. In order to achieve a heat dissipation effect with a high design requirement, it is necessary to increase the size of the cooling fins 1, but this will increase the space needed to install the cooling fins 1, with the result that the volume of the heat sink as a whole is larger.

US 2011/051370 A1 describes a carrier plate, upon the first section of which a first group of electronic components is placed, upon a second section of which is installed a plurality of cooling ribs for the removal of heat produced by the electronic components, wherein the cooling ribs are designed to be curved to a predetermined extent along their longitudinal axis and to lie in a plane parallel to the said carrier plate.

US 2016/285295 A1 describes a portable alternating current power supply assembly which has an extendable operational period and which provides an external power supply for a tool.

DE 10 2014 012349 A1 describes a cooling arrangement for heat-generating electrical components arranged in a housing of an electrical apparatus, especially a frequency converter for an electric motor.

WO 2012/098780 A1 describes an inverter apparatus comprising a case with a housing section for housing an inverter circuit board, wherein the housing section is divided into two spaces: a first housing section and a second housing section, wherein the first housing section is provided with heat radiation fins extending outwards, and has switching elements arranged therein.

US 2012/044646 A1 describes a cold plate having a surface for mounting a component thereto, a first path to flow cooling fluid therethrough in a vicinity of the surface and a housing mounted on the surface that extends from the surface.

EP 2 315 340 A1 describes a module having an electrically conducting support plate for current rectifying elements e.g. diodes, where the plate is prolonged by a heat sink.

US 2002/036889 A1 describes a housing for an electronic apparatus having heat generating components, such as a rectifier, comprises a bottom panel, at least one side panel and a lid, wherein the whole housing is adapted do constitute a heat sink.

US 2006/227504 A1 describes a heat-dissipating module of an electronic device comprising a fan, a first heat-dissipating component and a second heat-dissipating component. Further reference is made to DE 20 2010 018161 U1, US 2013/291564 A1 and US 2009/168356 A1.

### Content of the present invention

In response to the abovementioned problem in the prior art, the present invention proposes a completely new heat sink, which improves heat dissipation efficiency and has a more compact structure. Thus, the heat sink of the present invention is, on the whole, superior to a conventional heat sink product.

Specifically, the present invention provides a heat sink, comprising: a heat dissipation plate and at least one heat dissipation tube, the heat dissipation tube further comprising a first tube section, a bent part and a second tube section, with the first tube section of the heat dissipation tube being at least partially embedded in the heat dissipation plate, the second tube section being arranged outside the heat dissipation plate, and the first tube section and the second tube section being parallel to each other and connected via the bent part, wherein the heat dissipation tube is provided with at least one cooling fin extending outwards from an outer wall of the heat dissipation tube. The second tube section of the heat dissipation tube is arranged on a first outside surface of the heat dissipation plate, and a second outside surface, opposite the first outside surface, of the heat dissipation plate is a heat source mounting surface adapted to be in contact with a heat source, the second tube section of the heat dissipation tube is provided with an opening located in a position opposite the heat source mounting surface, an end opening of the first tube section leads to the outside of the heat dissipation plate, wherein the end opening is configured to suck in external air which in turn is discharged outwards from the opening. With this structure, the entire heat dissipation tube is in full contact with the heat dissipation plate, to enhance heat conduction.

According to an embodiment of the present invention, in the abovementioned heat sink, the heat dissipation tube is provided with multiple cooling fins arranged centrosymmetrically in a radial cross section of the heat dissipation tube, with each of the cooling fins extending in an axial direction of the heat dissipation tube. The cooling fins in this form can significantly increase the surface area of the entire heat sink, increasing the heat dissipation efficiency.

According to an embodiment of the present invention, in the abovementioned heat sink, the cooling fin is bent in a spiral manner in a radial cross section of the heat dissipation tube.

According to the present invention, the second tube section of the heat dissipation tube is provided with an opening located in a position opposite the heat source mounting surface. The opening can help to form an airflow by means of an air pressure difference, enhancing a heat dissipation effect.

According to an embodiment of the present invention, in the abovementioned heat sink, the opening is provided between two adjacent cooling fins.

According to an embodiment of the present invention, the abovementioned heat sink further comprises: a fan arranged directly opposite the bent part of the heat dissipation tube.

According to an embodiment of the present invention, in the abovementioned heat sink, the heat dissipation tube is a copper tube, and the heat dissipation plate is an aluminium plate.

According to another aspect of the present invention, a frequency converter is also provided, comprising a heat sink as discussed above.

It should be understood that both the general description of the present invention above and the detailed description thereof below are illustrative and explanatory, and intended to provide further explanation of the present invention as described in the claims.

### Description of the accompanying drawings

The accompanying drawings are included to provide further understanding of the present invention. They are recorded and form part of the present application. The drawings show embodiments of the present invention, and together with this description serve to explain the principles of the present invention. In the drawings:
Fig. 1 shows an embodiment of a heat sink in the prior art.
Fig. 2 shows an embodiment of a heat sink according to the present invention.
Fig. 3 shows the airflow direction during operation of the heat sink shown in fig. 2.
Fig. 4 shows the bottom structure of the heat sink shown in fig. 2.

Key to labels used in the drawings:
- 1: cooling fin
- 2: fan
- 10: heat sink
- 11: heat dissipation plate
- 12: heat dissipation tube
- 13: first tube section
- 14: bent part
- 15: second tube section
- 16: cooling fin
- 17: first outside surface
- 18: second outside surface
- 19: heat source
- 20: opening
- 21: fan
- 22: end opening

### Particular embodiments

Embodiments of the present invention are now described, making detailed reference to the accompanying drawings. Preferred embodiments of the present invention are now referred to in detail, examples thereof being shown in the accompanying drawings. In any possible situation, identical labels are used in all drawings to indicate identical or similar parts. In addition, although terms used in the present invention are selected from well known and widely used terms, some terms mentioned in the description of the present invention might be selected by the applicant according to his or her judgement, and the detailed meanings thereof are explained in the relevant parts of the descriptions herein. In addition, it is required that the present invention shall be understood not just through the actual terms used, but also through the meaning implied in each term.

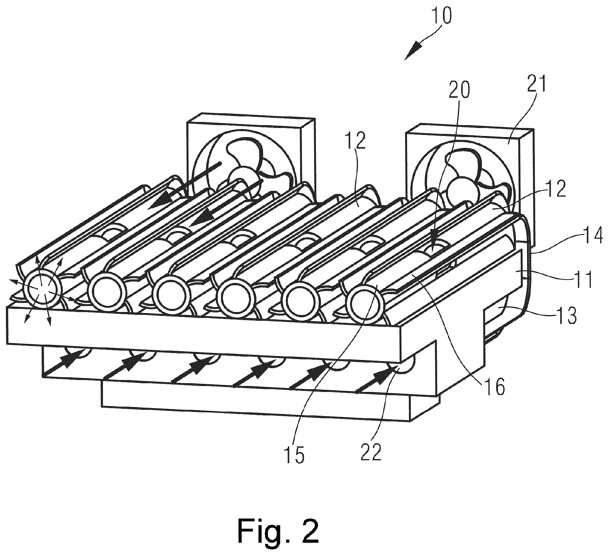

Reference is made to the accompanying drawings to discuss in greater detail the basic principles and preferred embodiments of the present invention. As fig. 2 shows, a heat sink 10 of the present invention mainly comprises: a heat dissipation plate 11 and at least one heat dissipation tube 12. The heat dissipation tube 12 further comprises a first tube section 13, a bent part 14 and a second tube section 15. The first tube section 13 of the heat dissipation tube 11 is at least partially embedded in the heat dissipation plate 11. The second tube section 15 is arranged outside the heat dissipation plate 11. The first tube section 13 and the second tube section 15 are parallel to each other and connected via the bent part 14. In particular, the heat dissipation tube 12 is provided with at least one cooling fin 16 extending outwards from an outer wall of the heat dissipation tube 12. Preferably, the heat dissipation tube 12 may be a copper tube; at the same time, the heat dissipation plate 11 may be an aluminium plate. With this structure, the entire heat dissipation tube 12 is in full contact with the heat dissipation plate 11, to enhance heat conduction. In addition, the cooling fin 16 can significantly increase the surface area of the entire heat sink 10, increasing the heat dissipation efficiency.

In the embodiment shown in fig. 2, the heat dissipation tube 12 may be provided with multiple cooling fins 16 arranged centrosymmetrically in a radial cross section of the heat dissipation tube 12. Each of these cooling fins 16 extends in an axial direction of the heat dissipation tube 12. In addition, the cooling fin 16 may also be bent in a spiral manner in a radial cross section of the heat dissipation tube 12, thereby obtaining a larger surface area within a smaller space.

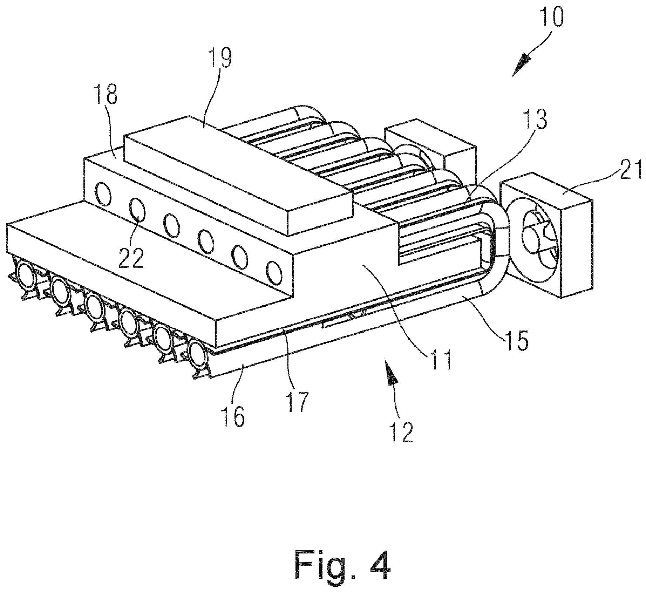

Turning to fig. 4, the second tube section 15 of the heat dissipation tube 12 is arranged on a first outside surface 17 of the heat dissipation plate 11, and a second outside surface 18, opposite the first outside surface 17, of the heat dissipation plate 11 is a heat source mounting surface adapted to be in contact with a heat source 19. As shown in figs. 2 - 4, for example, the heat dissipation plate 11 may have a T-shaped structure, the heat dissipation tube 12 may have a U-shaped structure, and these two components are arranged to be in contact with each other as fully as possible, to increase the heat dissipation efficiency.

In addition, the second tube section 15 of the heat dissipation tube 12 is provided with an opening 20, refer to fig. 2. The opening 20 is located in a position opposite the heat source mounting surface (second outside surface 18), and may be provided between two adjacent cooling fins 16. Moreover, the heat sink 10 may further comprise a fan 21 arranged directly opposite the bent part 14 of the heat dissipation tube 12.

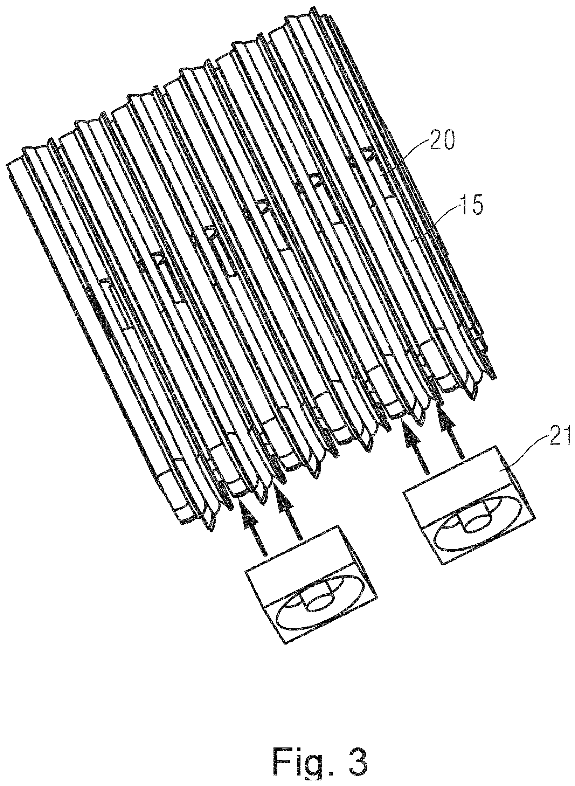

Thus, as shown in fig. 3, when the fan 21 is operating, an airflow on a surface of the second tube section 15 of the heat dissipation tube 12 forms an inside/outside air pressure offset of the second tube section 15, in turn causing air in the second tube section 15 to be discharged outwards from the opening 20 (an airflow direction being as shown in fig. 3), and then causing an end opening 22 of the first tube section 13 to suck in external air (an airflow direction being as shown in fig. 2), wherein the end opening 22 of the first tube section 13 leads to the outside of the heat dissipation plate 11 (as shown in figs. 2 and 4).

In summary, the present invention proposes a heat sink, and a frequency converter using such a heat sink. The heat sink employs a structure with a completely new design, to obtain higher heat dissipation efficiency in as small a space as possible, has better overall performance than a conventional heat sink product, and is especially suitable for a frequency converter product with a compact structure.

It will be obvious to those skilled in the art that various amendments and changes in form could be made to the abovementioned demonstrative embodiments of the present invention, without deviating from the scope of the present invention. Thus, the present invention is intended to cover amendments and changes in form to the present invention which fall within the scope of the attached claims.

## Claims

1. A heat sink (10), comprising: a heat dissipation plate (11) and at least one heat dissipation tube (12), the heat dissipation tube (12) further comprising a first tube section (13), a bent part (14) and a second tube section (15), with the first tube section (13) of the heat dissipation tube (12) being at least partially embedded in the heat dissipation plate (11), the second tube section (15) being arranged outside the heat dissipation plate (11), and the first tube section (13) and the second tube section (15) being parallel to each other and connected via the bent part (14), wherein the heat dissipation tube (12) is provided with at least one cooling fin (16) extending outwards from an outer wall of the heat dissipation tube (12);
wherein the second tube section (15) of the heat dissipation tube (12) is arranged on a first outside surface (17) of the heat dissipation plate (11), and a second outside surface (18), opposite the first outside surface (17), of the heat dissipation plate (11) is a heat source mounting surface adapted to be in contact with a heat source (19),
the second tube section (15) of the heat dissipation tube (12) is provided with an opening (20) located in a position opposite the heat source mounting surface, and
an end opening (22) of the first tube section (13) leads to the outside of the heat dissipation plate (11), wherein the end opening (22) is configured to suck in external air which in turn is discharged outwards from the opening (20).

2. The heat sink (10) according to claim 1, **characterized in that** the heat dissipation tube (12) is provided with multiple cooling fins (16) arranged centrosymmetrically in a radial cross section of the heat dissipation tube (12), with each of the cooling fins (16) extending in an axial direction of the heat dissipation tube (12).

3. The heat sink (10) according to claim 2, **characterized in that** the cooling fin (16) is bent in a spiral manner in a radial cross section of the heat dissipation tube (12).

4. The heat sink (10) according to claim 1, **characterized in that** the opening (20) is provided between two adjacent cooling fins (16).

5. The heat sink (10) according to claim 1, **characterized by** further comprising: a fan (21) arranged directly opposite the bent part (14) of the heat dissipation tube (12).

6. The heat sink (10) according to claim 1, **characterized in that** the heat dissipation tube (12) is a copper tube, and the heat dissipation plate (11) is an aluminium plate.

7. A frequency converter, **characterized by** comprising a heat sink (10) according to any of the preceding claims.

## Patentansprüche

1. Kühlkörper (10), umfassend: eine Wärmeableitungsplatte (11) und mindestens ein Wärmeableitungsrohr (12), wobei das Wärmeableitungsrohr (12) ferner einen ersten Rohrabschnitt (13), einen gebogenen Teil (14) und einen zweiten Rohrabschnitt (15) umfasst, wobei der erste Rohrabschnitt (13) des Wärmeableitungsrohrs (12) zumindest teilweise in der Wärmeableitungsplatte (11) eingebettet ist, der zweite Rohrabschnitt (15) außerhalb der Wärmeableitungsplatte (11) angeordnet ist und der erste Rohrabschnitt (13) und der zweite Rohrabschnitt (15) parallel zueinander sind und über den gebogenen Teil (14) verbunden sind, wobei das Wärmeableitungsrohr (12) mit mindestens einer Kühlrippe (16) versehen ist, die sich von einer Außenwand des Wärmeableitungsrohrs (12) nach außen erstreckt;
wobei der zweite Rohrabschnitt (15) des Wärmeableitungsrohrs (12) auf einer ersten Außenfläche (17) der Wärmeableitungsplatte (11) angeordnet ist und eine zweite Außenfläche (18), gegenüber der ersten Außenfläche (17), der Wärmeableitungsplatte (11) eine Wärmequellenbefestigungsfläche ist, die dazu eingerichtet ist, in Kontakt mit einer Wärmequelle (19) zu sein,
der zweite Rohrabschnitt (15) des Wärmeableitungsrohrs (12) mit einer Öffnung (20) versehen ist, die sich an einer Position gegenüber der Wärmequellenbefestigungsfläche befindet, und
eine Endöffnung (22) des ersten Rohrabschnitts (13) zur Außenseite der Wärmeableitungsplatte (11) führt, wobei die Endöffnung (22) dazu ausgelegt ist, Außenluft anzusaugen, die im Gegenzug aus der Öffnung (20) nach außen abgeführt wird.

2. Kühlkörper (10) nach Anspruch 1, **dadurch gekennzeichnet, dass** das Wärmeableitungsrohr (12) mit mehreren zentrosymmetrisch in einem radialen Querschnitt des Wärmeableitungsrohrs (12) angeordneten Kühlrippen (16) versehen ist, wobei sich jede der Kühlrippen (16) in einer axialen Richtung des Wärmeableitungsrohrs (12) erstreckt.

3. Kühlkörper (10) nach Anspruch 2, **dadurch gekennzeichnet, dass** die Kühlrippe (16) in einem radialen Querschnitt des Wärmeableitungsrohrs (12) spiralförmig gebogen ist.

4. Kühlkörper (10) nach Anspruch 1, **dadurch gekennzeichnet, dass** die Öffnung (20) zwischen zwei benachbarten Kühlrippen (16) bereitgestellt ist.

5. Kühlkörper (10) nach Anspruch 1, **dadurch gekennzeichnet, dass** er ferner Folgendes umfasst: ein Gebläse (21), das direkt gegenüber dem gebogenen Teil (14) des Wärmeableitungsrohrs (12) angeordnet ist.

6. Kühlkörper (10) nach Anspruch 1, **dadurch gekennzeichnet, dass** das Wärmeableitungsrohr (12) ein Kupferrohr ist und die Wärmeableitungsplatte (11) eine Aluminiumplatte ist.

7. Frequenzumrichter, **dadurch gekennzeichnet, dass** er einen Kühlkörper (10) nach einem der vorhergehenden Ansprüche umfasst.

## Revendications

1. Dissipateur de chaleur (10), comprenant : une plaque de dissipation de chaleur (11) et au moins un tube de dissipation de chaleur (12), le tube de dissipation de chaleur (12) comprenant en outre une première section de tube (13), une partie courbée (14), et une seconde section de tube (15), la première section de tube (13) du tube de dissipation de chaleur (12) étant au moins partiellement encastrée dans la plaque de dissipation de chaleur (11), la seconde section de tube (15) étant agencée à l'extérieur de la plaque de dissipation de chaleur (11), et la première section de tube (13) et la seconde section de tube (15) étant parallèles l'une à l'autre et raccordées par l'intermédiaire de la partie courbée (14), dans lequel le tube de dissipation de chaleur (12) est pourvu d'au moins une ailette de refroidissement (16) s'étendant vers l'extérieur à partir d'une paroi externe du tube de dissipation de chaleur (12) ;
dans lequel la seconde section de tube (15) du tube de dissipation de chaleur (12) est agencée sur une première surface extérieure (17) de la plaque de dissipation de chaleur (11), et une seconde surface extérieure (18), opposée à la première surface extérieure (17), de la plaque de dissipation de chaleur (11) est une surface de montage de source de chaleur adaptée pour être en contact avec une source de chaleur (19),
la seconde section de tube (15) du tube de dissipation de chaleur (12) est pourvue d'une ouverture (20) située dans une position opposée à la surface de montage de source de chaleur, et
une ouverture d'extrémité (22) de la première section de tube (13) conduit à l'extérieur de la plaque de dissipation de chaleur (11), dans lequel l'ouverture d'extrémité (22) est configurée pour aspirer de l'air externe qui, à son tour, est évacué vers l'extérieur depuis l'ouverture (20).

2. Dissipateur de chaleur (10) selon la revendication 1, **caractérisé en ce que** le tube de dissipation de chaleur (12) est pourvu de multiples ailettes de refroidissement (16) agencées de façon centrée symétriquement dans une section transversale radiale du tube de dissipation de chaleur (12), chacune des ailettes de refroidissement (16) s'étendant dans une direction axiale du tube de dissipation de chaleur (12).

3. Dissipateur de chaleur (10) selon la revendication 2, **caractérisé en ce que** l'ailette de refroidissement (16) est courbée à la manière d'une spirale en une section transversale radiale du tube de dissipation de chaleur (12).

4. Dissipateur de chaleur (10) selon la revendication 1, **caractérisé en ce que** l'ouverture (20) est prévue entre deux ailettes de refroidissement adjacentes (16).

5. Dissipateur de chaleur (10) selon la revendication 1, **caractérisé en ce qu'**il comprend en outre : un ventilateur (21) agencé de façon directement opposée à la partie courbée (14) du tube de dissipation de chaleur (12).

6. Dissipateur de chaleur (10) selon la revendication 1, **caractérisé en ce que** le tube de dissipation de chaleur (12) est un tube en cuivre, et la plaque de dissipation de chaleur (11) est une plaque en aluminium.

7. Convertisseur de fréquence, **caractérisé en ce qu'**il comprend un dissipateur de chaleur (10) selon de quelconques des revendications précédentes.
